# EUROPEAN PATENT APPLICATION

(11) **EP 4 545 954 A1**
(43) Date of publication of application: **30.04.2025**
(21) Application number: 23206048.3
(22) Date of filing: 26.10.2023
(51) Int. Cl.: G01N 24/08, G01R 33/54, G01R 33/56, G01R 33/30, G01R 33/48, G01R 33/483

(54) **METHOD FOR ENABLING HIGH-THROUGHPUT IMAGING OF INDUSTRIAL SAMPLES**

(71) Applicant: Orbem GmbH, 80935 Munich (DE)
(72) Inventor: Coello, Eduardo, 80935 Munich (DE); Skinner, Jason Graham, 80935 Munich (DE); Schützenberger, Anna, 80935 Munich (DE); Knowles, Benjamin Richard, 80935 Munich (DE); Kaçorri, Aldo, 80935 Munich (DE); Gómez Damián, Pedro Agustín, 80935 Munich (DE); Molina Romero, Miguel, 80935 Munich (DE); Laparidou, Maria, 80935 Munich (DE)
(74) Representative: Pelster Behrends Patentanwälte PartG mbB

(57) **Abstract**

The invention relates to a Method for automated non-invasive analysis of a predetermined feature in a multitude of industrial samples (100) of a predefined sample type, the method comprising the steps of: b) recording in a preparation MRI experiment first MRI data of the industrial sample (100) with the MR scanner (102) to obtain a navigator information comprising the recorded first MRI data, c) analysing the navigator information with an inference module (200) for deriving one or more MR experimental parameters for use in a subsequent MR experiment for the analysis of the predetermined feature in the industrial sample (100) using a machine learning module (202), d) recording in a subsequent MR experiment MR data of the industrial sample (100) with the MR scanner(102) using the derived one or more MR experimental parameters, and e) analysing the predetermined feature in the industrial sample (100) using the MR data of the industrial sample (100), wherein the machine learning module (202) is trained for deriving one or more MR experimental parameters for use in a subsequent MR experiment for the analysis of the predetermined feature in the industrial sample (100) by analysing navigator information using a training set comprising navigator information of different training samples and corresponding MR experimental parameters used in a subsequent MR experiment for the analysis of the predetermined feature in the training sample.

## Description

The present invention relates to a method for automated non-invasive analysis of a predetermined feature in a multitude of industrial samples of a predefined sample type, an inference module for deriving one or more MRI experimental parameters for use in a subsequent MRI experiment for the analysis of a predetermined feature in an industrial sample, a scanner system comprising said inference module and a corresponding computer program product.

In modern industry, advanced automation technologies have resulted in higher production and productivity, wherein industrial processes have undergone considerable changes in the past decades. In recent years, various industries have significantly increased the overall output, i.e. the number of processed industrial products per hour, resulting in high-throughput, i.e. fast processing and reduced processing times for each individual industrial product. At the same time, customers' expectations regarding product quality and/or the extent of official regulations have increased, so that high product qualities must be accomplished despite the high productivity. Furthermore, several industries rely on accurate assessment of the features and quality of relevant base materials, e.g. the fertility status of an egg in the case of hatcheries or the expected productivity of seeds in the agriculture industry. Therefore, enabling accelerated analysis of industrial samples is highly relevant for various industrial fields, both for quality control and property prediction.

A promising approach to satisfy this demand and to allow for a high-throughput analysis of samples are NMR (nuclear magnetic resonance) based techniques and in particular the use of Magnetic Resonance Imaging (MRI). The use of MRI techniques for providing information about e.g. the interior of industrial products has recently moved into focus. Herein, several different concepts for analysing properties of industrial samples with imaging techniques are discussed in the prior art, e.g. in EP 3 483 619 A1, US 6,149,956 A, WO 02/059586 A2, US 10,338,015 B2 and US 2019/011383 A1. Due to its fundamental relevance for the application potential of MRI in industrial application, a lot of attention is given to the optimization of the sample throughput, which is strongly influenced by the potential scan speed, the field of view that needs to be sampled and by the overall MRI processing rate.

Apart from reducing the number of samples, an approach for saving measurement time and for increasing the processing rate is to reduce the digitization rate and/or the number of experiments taken in the phase encoding dimension. This results in the acquisition of undersampled MRI data. Furthermore, shot repetition times for each scan and/or the number of scans taken in each sub-experiment can be reduced to further increase the processing rate. Using this approach, the overall time required for each sample can be reduced, so that an increase in throughput can be achieved, in particular when combined with techniques like parallel imaging.

For further increasing the throughput, methods for direct inference were suggested in the prior art that utilize machine learning to directly analyse undersampled MRI data, as is disclosed in EP 4202427 A1 and EP 4202468 A1, respectively. These methods allow for a significant increase in processing speed and result in a decrease of overall acquisition time.

While several prior art techniques allow for an increase in efficiency and enhanced throughput, there still exists a demand for further increasing these parameters and to reduce the time required for the analysis of each sample, without reducing the quality of the analysis, that is for example capable of reducing the amount of undersampling.

It was the primary objective of the present invention to overcome or at least reduce the disadvantages of the prior art.

In particular, it was the objective of the present invention to provide for a powerful method for analysing industrial samples with a high throughput allowing for fast sample processing and broad applicability in multiple industrial fields.

It was an objective of the present invention, that the respective method should be able to reduce the overall time required for the analysis of each industrial sample.

Furthermore, it was an objective of the present invention that the respective method should allow for high quality analysis of industrial samples, that should ideally be comparable to known methods that require significantly longer process times.

It was desired that the respective method should be applicable to a wide variety of industrial sample types and should allow for efficient simultaneous analysis of several samples and/or subsequent analysis with a high processing rate.

Furthermore, it was an additional objective of the present invention, that the respective method should yield particular reliable results, wherein it was desired that the susceptibility to human error should be reduced as much as possible, wherein most desirably the amount of training required for the process operators should be minimized. In this framework, it was an objective of the present invention that the respective method should allow for an efficient automatization, in particular on an industrial scale.

Likewise, it was a further objective of the present invention, that the respective method should be operable on a wide variety of different MRI systems, wherein it was desirable that existing MRI systems should be easily upgradeable to perform the respective method.

It was a further objective of the present invention, to provide for a powerful scanner system and a corresponding inference module that are suitable for use in the respective method. Likewise, it was an additional objective of the present invention to provide for a computer program product that enables steps of the respective method.

The inventors of the present invention have now found, that the above-described objectives can surprisingly be achieved, if a method for automated non-invasive analysis of a predetermined feature in a multitude of industrial samples of a predefined sample type is employed as defined in the claims. The respective method of the invention allows for real-time determination of optimal scan settings for use in subsequent MRI or NMR experiments, using magnetic resonance data obtained in a preparation MRI experiment with in combination a machine learning module which utilizes data-driven models to infer specific experimental parameter updates from the resulting MRI data, that can be employed in a subsequent magnetic resonance experiment for obtaining accurate and high-quality scans in the primary magnetic resonance experiment that is intended for analyzing the industrial sample. By specifically updating the MRI experimental parameters before the main experiment, e.g. by setting the field of vision to the precise location of the target feature of interest within the scanned industrial sample, and/or by setting the optimal orientation of the scan plane, and/or by adjusting the hardware settings, the relevant main experiment can be optimized to maximize the image quality per acquisition time. Beneficially, the present invention enables fully automated high-throughput imaging by precisely targeting features of interest and/or optimizing the acquisition parameters for scanning the feature of interest, drastically reducing the required sample coverage and/or increasing the signal to noise ratio obtainable per scan, and/or allowing for adjusting the resolution and/or optimizing the imaging MR plane, consequently reducing the acquisition time and increasing the throughput, wherein beneficially almost no specific training is required for the process operators to employ the method.

The aforementioned objectives are solved by the subject-matter of the present invention as defined in the claims. Hereinafter, the subject-matter of the invention is discussed in more detail, wherein preferred embodiments of the invention are disclosed.

It is particularly preferred to combine two or more of the preferred embodiments to obtain an especially preferred embodiment. Correspondingly, especially preferred is a method according to the invention, that defines two or more features of preferred embodiments of the present invention. Also preferred are embodiments in which a feature of one embodiment that is to some extent designated as preferred is combined with one or more further features of other embodiments that are designated to some extent as preferred. Features of preferred scanner systems, inference modules and computer program products result from features of preferred methods.

The present invention relates to a method for automated non-invasive analysis of a predetermined feature in a multitude of industrial samples of a predefined sample type, the method comprising the steps of:
a) conveying an industrial sample of the predefined sample type into an MR scanner,
b) recording in a preparation MRI experiment first MRI data of the industrial sample with the MR scanner to obtain a navigator information comprising the recorded first MRI data,
c) analysing the navigator information with an inference module for deriving one or more MR experimental parameters for use in a subsequent MR experiment for the analysis of the predetermined feature in the industrial sample using a machine learning module,
d) recording in a subsequent MR experiment MR data of the industrial sample with the MR scanner using the derived one or more MR experimental parameters, and
e) analysing the predetermined feature in the industrial sample using the MR data of the industrial sample,

wherein the inference module comprises a memory storing the machine learning module and a processor for controlling the inference module, wherein the inference module is configured to provide the navigator information as an input to the machine learning module and to analyse the navigator information using the machine learning module,
wherein the machine learning module is trained for deriving one or more MR experimental parameters for use in a subsequent MR experiment for the analysis of the predetermined feature in the industrial sample by analysing navigator information using a training set comprising navigator information of different training samples of the predefined sample type with the predetermined feature and corresponding MR experimental parameters used in a subsequent MR experiment for the analysis of the predetermined feature in the training sample,
wherein for a fraction of the training samples the subsequent MR experiment for the analysis of the predetermined feature meet a predefined quality criterion and wherein for a fraction of the training samples the subsequent MR experiment for the analysis of the predetermined feature did not meet a predefined quality criterion.

The method according to the invention is automated, i.e. operated predominately by automatic equipment, thereby enabling high throughput and mostly removing the need for process operators. In other words, the method uses machinery and electronics to perform most tasks, so that it can be carried out by machines or computers, in particular a scanner system of the invention, without needing human control. In theory, the method can be only partly automated, e.g. by including additional manual process steps or by using a manual conveyor. However, operating mostly or entirely automated is preferred.

The term "non-invasive" is well-known to the skilled person and defines that the method is non-destructive and does not require incisions or the insertion of instruments into the sample, or the extraction of content from the sample.

The method of the present invention is used for the analysis of a predetermined feature in a multitude of industrial samples of a predefined sample type.

The term "industrial samples" as used herein refers to samples coming from and/or being further processed in industrial facilities. In perfect agreement with the understanding of the skilled person, the term "industrial samples" does not comprise living animals or humans. Therefore, the method according to the invention does not comprise identification of a predetermined feature in human beings and living animals. Based on the needs of the respective industries and the excellent suitability of the method of the invention, a method according to the invention is preferred, wherein the industrial sample is designated for use in an industry that is selected from the group of agricultural industry, in particular farms and hatcheries, plastic industry, forestry industry and food industry, in particular confectionery production or in the use of seeds and nuts.

The industrial samples that are employed in the method according to the invention belong to a predefined sample type. The term "predefined sample type" as used herein relates to a sample class or sample category which is defined prior to the method of the present invention and will in most cases depend on the industry. Thus, samples of a predefined type generally display similar properties so as to be comparable to one another. In other words, the predefined sample type is a grouping criterion to group a number of industrial samples according to their type, nature, origin or properties, including shape, volume, composition and colour.

Depending on the sample type and the predetermined feature, all of the samples of the sample type or only a fraction of the samples may comprise the predetermined feature that shall be analysed in the method. For example, basically all eggs will comprise a yolk, but not all confectionery products may comprise the desired filling, e.g. a cherry. The method of the present invention is configured to analyse the predefined feature in a sample of the predefined sample type that actually comprises the predefined feature, so that the method of the present invention indirectly also is a method of identifying the absence of the predetermined feature in an industrial sample under study.

While this definition might appear unwieldy at first, there is no practical obstacle for the skilled person to define a sample type and to decide, if an industrial sample falls under the predefined sample type. For example, the predefined sample type may be "eggs", or more specifically "chicken eggs", or alternatively might be "pralines", or more specifically "pralines with cherry". In the vast majority of the cases, the predefined sample type will be whatever product is produced in the respective industrial facilities. Insofar, the skilled person readily understands that the identification of a predetermined feature in a more generic predefined sample type, e.g. "seeds" instead of "grape seeds", requires more effort in training the machine learning module and typically will require a larger training set for obtaining the adequate machine learning module as disclosed below. While this is not a problem of the method according to the invention, defining a highly generic predefined sample type may reduce the overall value of the predefined feature analysis provided by the method, e.g. because the optimized MR experimental parameters for analysing a feature in grape seeds might be very different from MR experimental parameters that are ideal for analysing the feature in grain seeds. Thus, it is preferred for most cases to define the predefined sample type as narrow as reasonably possible and to adapt the training set accordingly.

The industrial samples of the predefined sample type in principle can be any industrially usable product or item that substantially exhibits similar features, i.e. falling under a suitable grouping criterion. However, the inventors have found that the method of the present invention can be employed to certain industrial samples in a very efficient way, in particular due to their chemical and structural composition and therefore their typical NMR/MRI properties as well as their typical size, that allows efficient measurement in comparably small MR scanners, that can be arranged more easily in typical factories. Specifically, a method according to the invention is preferred, wherein the predefined sample type is selected from the group consisting of organic samples, preferably selected from the group of organic polymers, animal products, plants, and products derived from these materials, preferably plastics, organic tissues, meat, fish meat, eggs, fruits, seeds, wood and processed food and drinks, more preferably eggs, seeds, nuts, wood and chocolate products.

The term "predetermined feature" as used herein refers to a feature that has been specified, set or established in advance of the method of the present invention, wherein "predetermined" and "predefined" are herein used interchangeably and attributed to the "feature" and "sample type", respectively, to allow for better distinguishing between the two aspects. The predetermined feature that shall be analysed in the method of the invention can in principle be any characteristic, property, or attribute of the industrial sample. For example, the predetermined feature can e.g. be related to the industrial samples chemical composition, physical properties, and structural features, but also e.g. size ratios of elements in the samples. In view of the advantages of the method of the present invention, that allows for a subsequent MR experiment that uses optimized measurement parameters for analysing a localized feature, the predetermined feature preferably is a structural feature that is located somewhere in the large volume of the industrial sample, e.g. a yolk in an egg or a defect in a piece of wood. Thus, a method according to the invention is preferred, wherein the predetermined feature is selected from the group consisting of structural features in the industrial sample, preferably anatomical features, biological features, abnormalities, defects and impurities. Insofar, additionally or alternatively, a method according to the invention is preferred, wherein the predetermined feature is analysed with respect to chemical composition and/or morphological dimensions and/or its position in the industrial sample and/or spatial distribution of elements in the predetermined feature and/or size ratios of elements in the predetermined feature.

Exemplary is a method according to the invention, wherein the predefined sample type and the industrial sample is an egg, preferably a bird egg, more preferably a chicken egg, wherein the predetermined feature is a part of the egg, preferably the yolk, the white or the blastoderm. Specifically, a method according to the invention is preferred, wherein the hatchability of the egg is predicted based on the volume of the egg white and/or the volume of the egg yolk and/or the volume of the air-cell compartment and/or the ratio of these volumes and/or the position of the blastoderm.

The skilled person understands that the method according to the invention can be used to simultaneously analyse two or more predetermined features on the same sample or simultaneously in a multitude of samples that are processed simultaneously.

The skilled person understands that the analysis of a more generic predetermined feature, using the method of the present invention, e.g. the analysis of a more generic contaminant (including i. a. cherry pit, cherry stalk and worms) in industrial samples, will typically require more effort in training the machine learning module and typically will require a larger training set for obtaining the adequate machine learning module, in order to derive the optimized MR experimental parameters from the navigator information. Thus, similar to the sample type, it is preferred for most cases to define the predetermined feature as narrow as reasonably possible for the desired analysis.

In step a), the method of the present invention comprises the conveying of at least one industrial sample into an MR scanner. The skilled person understands that the conveying can be performed either manually or, in a strongly preferred embodiment, automatically. The conveying can comprise a pre-sorting mechanism and/or a transfer mechanism. In a preferred embodiment, the conveying is controlled by a transport controller, particularly a transport controller communicating with a central controller, which also controls the MR scanner. In particular, the conveying can be performed for multiple industrial samples at the same time, e.g. by using a suitable tray, wherein the method according to the invention preferably is conducted for all samples that are conveyed into the MR scanner. In view of this, a method according to the invention is preferred, wherein a multitude of industrial samples is conveyed into the MR scanner, sequentially and/or in parallel. Additionally or alternatively a method according to the invention is preferred, wherein the multitude of industrial samples are arranged for conveying in a regular pattern, preferably in a matrix configuration, preferably on a holder or tray that is suitable for holding a multitude of industrial samples of the predefined sample type.

As discussed above, there is a need for high-throughput analysis that ensures the quality and/or properties of a large number of industrial samples per time. Insofar the skilled person understands, that while the method of the invention is defined for an individual industrial sample for reasons of clarity, the method according to the invention is not a laboratory scale experiment, that is typically conducted on just a single sample, but rather is designed for analysing a multitude of industrial samples, in particular large numbers of industrial samples per time. Thus, a method according to the invention is preferred, wherein the method is applied for 2 or more, preferably 5 or more, more preferably 10 or more, most preferably 20 or more, in particular preferably 1000 or more, even more preferably 5000 or more, industrial samples. In particular, preferred is a method according to the invention, wherein the method is operated at a rate of 1000 or more industrial samples per hour, preferably 5000 or more industrial samples per hour. In other words, the term "an industrial sample" in the above definition could be replaced with "one, two or more industrial samples", preferably "two or more industrial samples".

Especially high throughput rates are typically obtained by capitalizing on the favorable potential of the method according to the invention to process several industrial samples at the same time and/or sequentially with a high rate, due to the beneficially high quality of the subsequent MR experiments that allow for efficient MR data acquisition. Correspondingly, it is preferred for basically all embodiments, to operate the method with a high sample throughput and/or processing rates. Therefore, a method according to the invention is preferred, wherein the method is sequentially applied to a multitude of industrial samples, that means that a multitude of samples are processed one after another, and/or wherein the method is simultaneously applied to a multitude of industrial samples, wherein preferably the method is sequentially applied several times simultaneously to a multitude of industrial samples, for example in batches of industrial samples.

The general structure and function of MR scanners and the concepts of NMR and MRI measurements itself, including typical MRI experiments, pulse sequences and techniques, are well known to the skilled person and need not be described herein. MR scanners that are suitable for the method according to the invention are commercially available from several suppliers and in most cases include the software and basic pulse programs required for recording MRI data or NMR data, respectively. More disclosure about the general concept of MRI is readily available in the prior art, e.g. from WO 2019/092265 A1. The skilled person understands that a method according to the invention is relevant, wherein the MR scanner comprises magnetic gradient coils in one, two or three dimensions, configured to induce a magnetic gradient in the static magnetic field, preferably in the measurement zone, and/or wherein the MR scanner comprises one or more radio-frequency coils configured to apply radio-frequency magnetic fields, preferably in the measurement zone. Especially preferred for basically all embodiments of the invention is a method according to the invention, wherein the MR scanner is an MRI scanner.

With respect to the hardware, a method according to the invention is preferred, wherein the MR scanner comprises a magnet that generates a static magnetic field, wherein the magnetic field preferably has a magnetic field strength in the range of 0.05 to 9.4 Tesla, more preferably in the range of 0.3 to 7 Tesla, wherein the MR scanner typically comprises a measurement zone, that is typically located in the centre of the static magnetic field, wherein the industrial sample is in the measurement zone during the measurements. The respective magnetic field strengths have proven to be a very efficient compromise between the price of the hardware, the respective maintenance costs and the workplace safety on the one hand and the achievable signal-to-noise ratios on the other hand. The use of optimized MR experimental parameters in the subsequent MR experiment and the resulting benefits in the signal-to-noise and/or overall acquisition time allow the usage of comparably low field strengths further contributing to the large degree of industrial applicability.

In step b) of the method of the present invention, a preparation MRI experiment is conducted for the industrial sample, that hereinafter is sometimes also referred to as the "navigator experiment", to facilitate understanding. This preparation MRI experiment is optimized for fast acquisition and intended to provide first MRI data, wherein this first MRI data is part of the navigator information, that itself can comprise further information, e. g. about the MRI experimental parameters used to acquire the first MRI data or information about the sample batch. The first MRI data can beneficially be of comparably low quality itself, and would e.g. not be suitably for reliably analysing the predetermined feature, but instead is used in the method of the present invention to derive optimized MR experimental parameters for use in the subsequent main experiment, in order to optimize the efficiency of said main experiment.

In case only one sample is processed at a time, the preparation MRI experiment is conducted at the respective sample. However, it is an advantage of the method of the present invention, that the navigator experiment can also be used for obtaining the optimized experimental parameters for a multitude of samples at the same time, to optimize the acquisition parameters. In this case, a method of the invention is preferred, wherein the method is applied for two or more samples simultaneously, wherein the first MRI data is collected for each industrial sample individually to obtain a navigator information for each industrial sample, or wherein the method is applied for two or more samples simultaneously, wherein the first MRI data is collected for a set of two or more industrial samples combined to obtain a navigator information for the set of two or more industrial samples.

The skilled person understands, that the advantage of the method of the present invention are obtained due to the fact that the steps b) and c) are conducted for each industrial sample before steps d) and e). Thus, when analyzing a multitude of industrial samples, with the method of the invention, steps b) and c) are conducted multiple times. While it might be possible to combine the method of the present invention with regular measurements, that do not use a navigator experiment, there are few reasons for not using the method of the present invention for all samples under study.

While the preparation MRI experiment could be used to only optimize the general acquisition parameters of the subsequent MR experiment, like pulse length or spacing, it is particularly preferable to use the preparation MRI experiment to specifically target a structural feature in a greater volume of the industrial sample. Therefore, a method of the invention is especially preferred, wherein the first MRI data comprises spatial information relating to the predetermined feature, preferably spatial information about signal magnitude and/or signal phase and/or real part of signal and/ or imaginary part of signal.

In principle, the method of the present invention is not limited to the specific type of MRI experiment that is used for the navigator scan. Exemplary is a method according to the invention, wherein the preparation MRI experiment is a one-dimensional, two-dimensional or higher dimensional MRI experiment, preferably a two-dimensional or higher dimensional MRI experiment, and/or wherein the first MRI data is one-dimensional, two-dimensional or higher dimensional MRI data, preferably two-dimensional or higher dimensional MRI data.

In order to minimize the overall acquisition time of the preparation MRI experiment and the subsequent MR experiment, it is preferred, to reduce the contribution of the preparation MRI experiment as much as possible. A method according to the invention is preferred, wherein the preparation MRI experiment is conducted with an overall measurement time of 200 ms or less, preferably 100 ms or less, more preferably 50 ms or less.

Due to the beneficial fact that the first MRI data is not necessary for the actual analysis of the feature (although it can be included into the analysis if desired), the inventors were able to identify suitable measures to further maximize the efficiency of the navigator scan.

As a first option, it is advantageously possible to utilize known efficiency enhancing MRI acquisition techniques. Such efficiency enhancing MRI acquisition techniques, like the well-known gradient encoding methods, are known in the art but typically reduce the resolution of the MRI data. While the use of such efficiency enhancing MRI acquisition techniques is often detrimental for a high quality analysis of features of interest, it is typically not problematic for the preparation MRI experiment, as the main goal of the navigator experiment can still be fulfilled. Synergistically, the use of machine learning reduces the effect of such efficiency enhancing MRI acquisition techniques, as the machine learning module can efficiently be trained with lower resolution images. In view of this, a method according to the invention is preferred, wherein the preparation MRI experiment is conducted as a two-dimensional or higher dimensional MRI experiment, using efficiency enhancing but resolution reducing MRI acquisition methods, preferably gradient encoding methods, for example spiral, radial or echo-planar.

Additionally or alternatively a further increase in efficiency, that is enabled by the use of machine learning, is that the first MRI data does not necessarily need to be brought in a form that can be easily interpreted by humans, e.g. by Fourier-transform. Instead, the machine learning module is advantageously capable of direct inference from non-processed first MRI data, thereby reducing the processing effort required in the method. Thus, a method according to the invention is preferred, wherein the first MRI data comprises raw MRI data and/or processed MRI data, in particular a Fourier transform in one, two or three dimensions, preferably raw MRI data. In other words, a method according to the invention is preferred, wherein the first MRI data does not comprise a fully sampled MRI image.

In particular, if the preparation MRI experiment is a two-dimensional experiment, it is expedient for some sample types, especially those with a larger volume, to conduct some subexperiments in order to ensure that the feature of interest is caught in the navigator experiment. This way, it can be avoided that the preparation MRI experiment misses the feature of interest when conducting a two-dimensional scan through the sample, e.g. because a cherry pit is not located in the middle of the praline. Thus, a method according to the invention is preferred, wherein the preparation MRI experiment comprises two or more, preferably three or more, subexperiments for the industrial sample, wherein the subexperiments are preferably conducted at different positions in the industrial sample and/or along different lines through the sample and/or along different planes through the industrial sample, and/or wherein the navigator information comprises first MRI data of two or more different subexperiments for the industrial sample, wherein the subexperiments are preferably conducted at different positions in the industrial sample and/or along different lines through the sample and/or along different planes through the industrial sample.

While the preparation MRI experiment is used for deriving optimal experimental parameters for the subsequent MR experiment, it is clear to the skilled person that the preparation MRI experiment needs to be conducted with experimental parameters itself. Especially for enabling efficient data processing with the machine learning module, it is highly advantageous to employ a predefined set of MRI experimental parameters for the preparation MRI experiments, wherein preferably the same predefined set of MRI experimental parameters is used for all preparation MRI experiments, that can for example be optimized for the general sample type. However, it can be beneficial for some cases that only a part of the parameters are preset and instead to keep some of the parameters that were optimized in the preceding optimization stage, e.g. if such experimental MRI parameters are hardware-related and more difficult to adjust on a short time scale. In view of this, a method according to the invention is preferred, wherein the preparation MRI experiment is conducted with a predefined set of MRI experimental parameters, wherein the predefined set of MRI experimental parameters preferably is obtained by a calibration experiment on an industrial sample, wherein the predefined set of MRI experimental parameters is preferably used for all preparation MRI experiments for the multitude of industrial samples. Only for some cases preferred is a method according to the invention, wherein the preparation MRI experiment is conducted with a set of MRI experimental parameters that corresponds at least partially, preferably at least with respect to the hardware configuration, to the MR experimental parameters that were used for recording MR data for a preceding industrial sample, preferably for the immediately preceding industrial sample.

The preparation MRI experiments are used to derive experimental parameters for a subsequent magnetic resonance experiment. In the framework of the present invention, this subsequent experiment can be an NMR experiment or an MRI experiment, respectively. In order to comprise both options, the subsequent experiment and the respected data are labeled using the abbreviation "MR", for magnetic resonance. Whether the subsequent MR measurement is an NMR and/or MRI experiment will depend on the type of analysis that the skilled person intends to conduct, wherein the method of the present invention can in principle be adopted for any type of subsequent MR experiment. Based on the experience of the inventors, MRI experiments will be more preferred for most cases due to the high amount of information that can be derived from the respective images. Exemplary is a method according to the invention, wherein the subsequent MR experiment is a one-dimensional, two-dimensional or higher-dimensional MR experiment. For some cases preferred is a method according to the invention, wherein the subsequent MR experiment is an NMR experiment, preferably a localized NMR experiment, and/or. wherein the MR experimental parameters are NMR experimental parameters, and/or wherein the MR data is NMR data. More preferred is a method according to the invention, wherein the subsequent MR experiment is an MRI experiment, and/or, wherein the MR experimental parameters are MRI experimental parameters, and/or wherein the MR data is second MRI data.

The skilled person understands that it is expedient to focus on the same nucleus in both the preparation MRI experiment and the subsequent MR experiment. Although it might be possible to locate a feature of interest in the navigator experiment using a different nucleus than the one used in the main experiment, it is hard to imagine any advantages that would be connected with such a process. A method according to the invention is preferred, wherein the preparation MRI measurement is a 1H-, 13C-, 23Na- or 31P-MRI-measurement, preferably a 1H- or 13C-MRI-Measurement, more preferably a 1H-MRI-Measurement. Additionally or alternatively, a method according to the invention is preferred, wherein the subsequent MR measurement is a 1H-, 13C-, 23Na- or 31P-MR-measurement, preferably a 1H- or 13C-MR-Measurement, more preferably a 1H-MR-Measurement. Most preferred for almost all cases is a method according to the invention, wherein the preparation MRI measurement and the subsequent MR measurement measure the same nucleus.

The skilled person is well aware of the plethora of experimental parameters that can be adjusted in order to affect the outcome of an MR experiment, wherein such parameters can be associated with parameters that can be controlled by a software, e.g. pulse scheme or the number of scans, or with the hardware, like configuration parameters regarding the gradients and acquisition frequency. It is clear to the skilled person that optimized experimental parameters either result in an increased signal quality and/or in a reduced acquisition effort, e.g. because less subexperiments are required in view of a reduced field of vision that needs to be covered. The inventors were able to identify potential experimental MR parameters, that can efficiently be derived from the navigator experiments.

Preferred is a method according to the invention, wherein the MR experimental parameters comprise experimental parameters regarding the hardware configuration of the MR scanner, preferably regarding the conveyor speed and/or the sample positioning in the MR scanner and/or configuration parameters regarding the magnetic field and/or configuration parameters regarding the gradients and acquisition frequency. Additionally or alternatively, a method according to the invention is preferred, wherein the MR experimental parameters comprise experimental parameters regarding the number of scans and/or the pulse sequence and/or the field of view, preferably the field of view of the MRI experiment.

For several cases, in particular for subsequent NMR experiments, preferred is a method according to the invention, wherein the MR experimental parameters comprise experimental parameters regarding the number of scans and/or the pulse sequence, preferably regarding the number of scans and/or the pulse length and/or the evolution times and/or the repetition times and/or spacing of increments.

Most preferred is a method according to the invention, wherein the MR experimental parameters comprise experimental parameters regarding the field of view of the MR experiment, wherein the field of view is preferably reduced so that not the entire industrial sample is sampled. While for some localized NMR sequences, it would be possible to modify experimental parameters regarding field of view, the adjustment of field of view is especially preferred for subsequent MRI experiments.

It is neither possible nor expedient to generally define absolute values for the experimental MR parameters, as the relevant parameters depend strongly on the MR scanner, the MR experiment, the nuclei under study, the sample type, the predetermined feature of interest, and several other parameters. However, manually identifying a set of initial experimental parameters for use in a preparation MRI experiment is a routine task for the skilled person that is aware of how to measure and/or calibrate the parameters needed for adjustment and/or calibration of the MR scanner. In practice, the different parameters are oftentimes optimized for obtaining the best signal-to-noise ratios on a standard, for example by incrementally adjusting the individual parameters for a reference sample of the predefined sample type.

The skilled person understands that the subsequent MR measurement will be used for analysing the respective feature of interest and that higher quality data is desired. Therefore, there exists a target conflict between maximizing the data quality and keeping the overall acquisition time low. Preferred is a method according to the invention, wherein the subsequent MR experiment is conducted with an overall measurement time of 5 s or less, preferably 2 s or less, more preferably 1 s or less.

Yet, for most cases the subsequent MR experiment will have a longer acquisition time than the navigator experiment. Thus, relevant for most cases will be a method according to the invention, wherein the subsequent MR experiment has a longer overall measurement time than the preparation MRI experiment, preferably by a factor of 10 or more, preferably a factor of 5 or more, more preferably by a factor of 2 or more, most preferably by a factor of 1,5 or more. Exemplary is a method according to the invention, wherein the subsequent MR experiment is conducted with an overall measurement time of more than 200 ms, alternatively more than 250 ms, further alternatively more than 300 ms.

After deriving the MR experimental parameters from the navigator information, the respective parameters are used in the subsequent MR experiment. Preferred is a method according to the invention, wherein the derived MR experimental parameters are provided by the inference module to the MR scanner to update the MR experimental parameters for use in the subsequent MR experiment on the industrial sample.

In order to allow for fast processing, the inventors found that is beneficial to use a low-latency communication architecture that enables fast processing in the inference module and data transfer for providing the MR experimental parameters to the MR scanner. Based on the experiments of the inventors, the main contributor to the latency will typically be the time required for analysing the navigator information with the inference module, e.g. for image reconstruction and inference of the respective MR experimental parameters. Insofar, it is expedient to employ powerful computer hardware with high bandwidth data transfer techniques and to adjust the software architecture to optimize the internal data processing speed. In particular, a method according to the invention is preferred, wherein the method is operated with a low-latency communication architecture for providing the navigator information to the inference module, analysing the navigator information with the inference module and providing the derived MR experimental parameters to the MR scanner, wherein the low-latency communication architecture enables the transfer of navigator information between the MR scanner and the inference module, the analysing of the navigator information with the inference module and the provision of the MR experimental parameters to the MR scanner in less than 300 ms, preferably less than 200 ms, more preferably less than 100 ms.

The step of deriving the MR experimental parameters from the navigator information is conducted using a machine learning module that is trained for the respective task. The inference module itself is a physical device and can be a typical data processing device, e.g. a computer. In agreement with this, the inference module comprises a memory, i.e. a computer-readable storage, for storing e.g. data or software as well as a processor, i.e. a digital circuit that is able to perform operations on an external data source, for controlling the inference module. As the hardware infrastructure of the inference module is not critical for the method of the present invention, it is expedient to define the presence of only the basic components of an electronic data processing system, i.e. the memory and the processor, wherein for both of these components typical elements can be used that are commercially available, wherein the inference module can also comprise other components of typical data processing systems, e.g. power supply, mouse, keyboard, displays, network connectors etc. While such an inference module can be included directly into the MR scanner, where it can e.g. also be used to control the conveyor, the inventors suggest that a centralized version is preferred, e.g. in the form of a cloud solution, in order to reduce the amount of computational capacity that is required in the industrial facilities, wherein the centralized processing also facilitates the further training of the machine learning module, if the input of several MR scanners is available as data basis. Thus, conceivable is a method according to the invention, wherein the inference module is included in the MR scanner, while preferred is a method according to the invention, wherein the inference module is provided on a decentral data processing device, preferably an external server, wherein the inference module is more preferably provided by a cloud computing device.

The processor of the inference module is used for controlling the inference module, wherein the inference module is configured to provide the navigator information as an input to the machine learning module and to analyse the navigator information using the machine learning module. The skilled person understands that this configuration is established in the typical way, e.g. by using software that can be programmed by the skilled person himself or can be provided by typical specialized programming companies. Thus, the inference module typically comprises computer executable code, that can be stored in the memory, which comprise machine executable instructions or a program which causes a processor and the inference module to perform their respective tasks in the method of the present invention. Suitable designs for assemblies from processors and memory are e.g. disclosed in EP 3 704 666 B1.

A core component of the inference module is the machine learning module that is stored in the inference module's memory, and therefore usable by the inference module for analysing the navigator information by providing the navigator information to the machine learning module. The machine learning module processes the input and derives one or more, preferably two or more, more preferably substantially all relevant, MR experimental parameters that should be used in the subsequent MR experiment for increased quality, wherein the output of the machine learning module is e.g. processed by the inference module and the processor, respectively, in order to update the experimental settings of the MR scanner.

In recent years, employing machine learning techniques or so-called "artificial intelligence" has become a promising approach for solving different technical problems in several industrial fields. Today, machine learning, its core concepts and its implementation are well-known in the art and several companies offer commercial solutions for implementing machine learning. While some skilled persons that have their focus in the field of MRI and/or in the field of quality control would potentially have to study some literature before setting up some of the more complex machine learning solutions entirely on their own, this skill is not necessarily required for putting the method of the invention into practice. Suitable machine learning algorithms and codes, that can be adapted to the present invention, are available from the prior art and from commercial service providers if required. In practice, in most industries the implementation of the machine learning aspects of the present invention will probably be provided by skilled persons in the field of machine learning and data scientists that have no problems in providing a suitable machine learning module in view of the disclosure of the present invention, wherein these skilled persons can e.g. be part of a team of employees or technical experts of external IT-service providers. Insofar, the machine learning module is similar to the MR scanner in that its foundation oftentimes will be provided by specialized companies.

The inference module uses the machine learning module for analysing the navigator information and the first MRI data, respectively. In agreement with the understanding of the skilled person, the machine learning module is the entity, e.g. a program, that is actually analysing the navigator information and can derive MR experimental parameters from it. For this, the machine learning module typically comprises both data and a procedure for using the data to make a prediction, sometimes called prediction algorithm. The machine learning module itself does not necessarily need to be able to further "learn" or "train" itself, but can exist, e.g. in the form of a program comprising the trained machine learning module, and continuously serve its task in the same way.

In agreement with the skilled persons understanding, machine learning modules can -as a simplification- be obtained by running (or fitting) a machine learning algorithm, sometimes called learning rule or learning algorithm, on a data set, that is oftentimes called training set. Thus, by running a machine learning algorithm on a training set of data, a machine learning module can be obtained or an existing machine learning module can be modified. Thus, by using the machine learning algorithm on the training set the machine learning module is trained for its specific task. In the framework of the present invention and in agreement with the established wording, the machine learning module is defined to be trained, wherein the training is specified by defining the training set. An exemplary disclosure for the use of machine learning in the field of MRI can be found in EP 3 704 666 B1, that provides additional information for further understanding of the technological background.

In practice, the choice of the machine learning algorithm used for obtaining the machine learning module will in most cases depend on the industrial samples and/or the type of subsequent MR experiment for that experimental parameters shall be derived. Yet, the inventors were able to identify suitable machine learning algorithms that can be used to generate the machine learning module, that is correspondingly based on the respective machine learning algorithm. In particular, a method according to the invention is preferred, wherein the machine learning module is based on a machine learning algorithm, wherein the machine learning algorithm is selected from the group consisting of regression algorithms, linear classifiers, instance-based algorithms, regularization algorithms, decision tree algorithms, bayesian algorithms, clustering algorithms, association rule learning algorithms, artificial neural network algorithms, deep learning algorithms, dimensionality reduction algorithms and ensemble algorithms, preferably linear classifiers, artificial neural network algorithms and deep learning algorithms. Correspondingly, a method according to the invention is preferred, wherein the machine learning module is obtained by applying a machine learning algorithm on the training set, wherein the machine learning algorithm is selected from the group consisting of regression algorithms, linear classifiers, instance-based algorithms, regularization algorithms, decision tree algorithms, bayesian algorithms, clustering algorithms, association rule learning algorithms, artificial neural network algorithms, deep learning algorithms, dimensionality reduction algorithms and ensemble algorithms, preferably linear classifiers, artificial neural network algorithms and deep learning algorithms. Herein, the machine learning algorithms themselves are known in the prior art and can be employed by the skilled person in view of the industrial sample and the predetermined feature.

Based on this, the inventors identified specific types of machine learning modules that have proven to provide excellent results in deriving MR experimental parameters from navigator information, and that are therefore explicitly preferred for all embodiments. Specifically, a method according to the invention is especially preferred, wherein the machine learning module is based on a deep learning network or an artificial neural network, preferably a deep learning network. Herein, these types of machine learning modules are known to the skilled person and e.g. described in more detail in EP 3 704 666 B1.

Due to the large amounts of corresponding navigator information and MR data of the subsequent MR experiment, that are typically recorded during an industrial scale use of the method of the present invention, it is highly recommended to provide for a mechanism for continued training of the machine learning module, to continuously enhance the performance and accuracy of the identification. Thus, a method according to the invention is especially preferred, wherein the inference module is further trained based on sets of navigator information and corresponding MR data that were collected in the method of the present invention.

While the skilled person chooses the machine learning algorithm based on his general knowledge and his specific needs, it is the training of the machine learning module and therefore the training set that connects the machine learning modules of the present invention with each other. According to the invention, the machine learning module is trained for deriving one or more MR experimental parameters for use in a subsequent MR experiment for the analysis of the predetermined feature in the industrial sample by analysing navigator information using a training set comprising navigator information of different training samples of the predefined sample type with the predetermined feature and corresponding MR experimental parameters used in a subsequent MR experiment for the analysis of the predetermined feature in the training sample, wherein for a fraction of the training samples the subsequent MR experiment for the analysis of the predetermined feature meet a predefined quality criterion and wherein for a fraction of the training samples the subsequent MR experiment for the analysis of the predetermined feature did not meet a predefined quality criterion. In other words, for each navigator information and its corresponding first MRI data in the training set, a set of derived MR experimental parameters is available, wherein it is known, if the respective parameters resulted in a sufficiently high-quality subsequent MR experiment or not. Therefore, the training of the machine learning module is a supervised training, i.e. a training based on input data with known results. In this training process predictions are made, which are manually or automatically corrected when turning out wrong. The desired level of accuracy is achieved through repetitions of the afore-mentioned process.

The training samples for the training of the machine learning module for deriving the MR experimental parameters are inherently represented by industrial samples of the same predefined sample type that shall be processed in the method of the invention, i.e. egg training samples for analysing features in eggs. It is known that the typical accuracy of the prediction i. a. depends on the quantity and quality of the training samples.

For some machine learning based techniques, e.g. for improvement of image quality or for the removal of artefacts like disclosed in e.g. EP 3 704 666 B1, methods are suggested for generating an artificial training set. However, the inventors found that this is not easily possible and, more importantly, not expedient for the method of the present invention. Since the method according to the invention is employed in high throughput industries and directed at the analysis of features that are relevant for these industries, potential samples that exhibit the predetermined feature (or not, respectively) are typically available in sufficient numbers, at least after a few days of operation, and it is easy to collect large amounts of usable data. In some cases, suitable samples can also be generated artificially, e.g. by intentionally creating mechanical defects in samples.

The required training data is e.g. readily obtained by recording first MRI data as navigator information for different training samples applying different MR experimental parameters and evaluating the quality of the outcome. Beneficially, the supervised learning can be combined with manual optimization operations, so that the training set can potentially comprise combinations of (essentially) the same navigator information, together with different sets of experimental parameters, of which only a fraction results in the desired quality, wherein the respective experimental parameters that meet the quality criterion could be derived by manual optimization.

Generally, a method according to the invention is preferred, wherein the training set comprises first MRI data of different training samples of the predefined sample type that was recorded with the same type of MR scanner used in the method, wherein preferably similar, more preferably basically identical, experimental parameters were employed for recording the first MRI data of the training samples as are used in the method. Thus, preferred is a method according to the invention, wherein the training set comprises navigator information and corresponding MR experimental parameters of different training samples of the predefined sample type that was recorded with the same type of MR scanner used in the method, preferably recorded with the identical MR scanner. Additionally or alternatively, a method according to the invention is preferred, wherein the training set comprises navigator information and corresponding MR experimental parameters of industrial samples previously analysed in the method for that MR data was recorded in the subsequent MR experiment that e a predefined quality criterion, wherein the machine learning module is preferably further trained from time to time. Additionally or alternatively, a method according to the invention is preferred, wherein the fraction of the training samples for that the predefined quality criterion is met is in the range of 10 to 90 %, preferably in the range of 20 to 80 %, more preferably in the range of 30 to 70 %, most preferably in the range of 40 to 60 %. Additionally or alternatively, a method according to the invention is preferred, wherein the training set comprises 5000 or more, preferably 10000 or more, more preferably 20000 or more, in particular 10000 to 50000 sets of navigator information and corresponding MR experimental parameters.

Only for the sake of completeness it is noted that the skilled person understands that a pronounced lack of coherence between the training samples and the industrial samples employed in the method according to the invention can reduce the efficiency of the method, in particular when combined with a comparably generic definition of the sample type. For example, if the skilled person intends to use the method of the present invention on chicken eggs, he is aware that the accuracy and efficiency of the method according to the invention may be reduced, if the employed training set for eggs comprises 90 % training data that was recorded for ostrich eggs.

Likewise, the skilled person is aware that the above definition of the method according to the invention and the training of the machine learning module implies that the training set comprises navigator information in the same format as the analysed navigator information.

It is expedient to establish a process for those cases, in that the navigator experiment does not detect the feature of interest. This could for example be due to the industrial sample not exhibiting the respective feature (e.g. because it is free of defects) or because a two-dimensional MRI experiment did not detect the feature of interest in a larger volume of the industrial sample. The inventors suggest that in these cases it is expedient to re-measure in a different preparation MRI experiment, in order to better detect the feature of interest, or to use predetermined MR experimental parameters as a fallback position for the main scan. Thus, a method according to the invention is preferred, wherein the machine learning module is trained to derive predetermined MR experimental parameters for use in a subsequent MR experiment if the navigator information comprises no first MRI data that can be attributed to the predetermined feature or not enough first MRI data that can be attributed to the predetermined feature or if the first MRI data that can be attributed to the predetermined feature does not meet a predefined quality criterion. Additionally or alternatively, a method according to the invention is preferred, wherein the machine learning module is trained to send a remeasure-signal to the MR scanner if the navigator information comprises no first MRI data that can be attributed to the predetermined feature or not enough first MRI data that can be attributed to the predetermined feature, or if the first MRI data that can be attributed to the predetermined feature does not meet a predefined quality criterion, wherein the steps b) and c) are repeated for the industrial sample, wherein the following preparation MRI experiment is preferably conducted using different MRI experimental parameters, in particular with respect to the position in the industrial sample and/or the direction through the sample. The skilled person understands that the respective training can be made using a training set comprising navigator information of different training samples of the predefined sample type, wherein for a fraction of the training samples the first MRI data comprises no first MRI data that can be attributed to the predetermined feature or not enough first MRI data that can be attributed to the predetermined feature or if the first MRI data that can be attributed to the predetermined feature does not meet a predefined quality criterion, wherein the respective training can be combined with the training for the deriving of one or more MR experimental parameters described above.

As an alternative to the aforementioned embodiments, the inventors suggest that the absence of first MRI data that can be attributed to the predetermined feature can be used to further increase throughput of the method by skipping the subsequent MR experiment for the respective sample. In other words, it is assumed that the predetermined feature is entirely absent based on the navigator experiment, making the subsequent MR experiment unnecessary. In this case, a method according to the invention is preferred, wherein steps d) and e) are not conducted for an industrial sample if the navigator information recorded for the industrial sample comprises no first MRI data that can be attributed to the predetermined feature, wherein the method is instead conducted for a subsequent industrial sample.

The inventors suggest that it is expedient for most cases to only skip the subsequent MR experiment if the inference module is sufficiently confident that the feature of interest is completely absent and that its absence is possible and logical in the context of the sample. For example, skipping the subsequent MR experiment in the absence of first MRI data that can be attributed to the predetermined feature is less preferred, if e.g. the industrial sample should inherently exhibit the predetermined feature or if the first MRI data is not sufficient to rule out the absence of the predetermined feature, e.g. because the feature could be located in a volume of the industrial sample that was not sufficiently covered by the navigator experiment. For example, the sufficient certainty can be achieved if the machine learning module can derive from the first MRI with sufficient confidence that the respective industrial sample belongs to a certain class of the sample type that precludes the existence of the predetermined feature. In view of this, a method according to the invention is preferred, wherein the machine learning module is trained to derive a confidence indicator from the first MRI data if the navigator information recorded for the industrial sample comprises no first MRI data that can be attributed to the predetermined feature, wherein the confidence indicator correlates with the probability that the predetermined feature is absent in the industrial sample, wherein steps d) and e) are not conducted for an industrial sample if the confidence indicator meets a predefined confidence criterion, wherein preferably steps b) and c) are repeated for the industrial sample or step d) is conducted using predetermined MR experimental parameters if the confidence indicator does not meet the predefined confidence criterion. Again, the skilled person understands that the necessary training can be made using a training set comprising navigator information of different training samples of the predefined sample type, wherein for a fraction of the training samples the first MRI data comprises no first MRI data that can be attributed to the predetermined feature or not enough first MRI data that can be attributed to the predetermined feature or if the first MRI data that can be attributed to the predetermined feature does not meet a predefined quality criterion, wherein it is known for the training samples if the predetermined feature is absent in the training samples, wherein preferably boundary conditions are provided that correlate with the inherent probability of the absence of the predetermined feature in industrial samples of the predefined sample type. Again, the respective training can be combined with the training for the deriving of one or more MR experimental parameters described above.

The resulting MR data, i.e. the NMR- and/or MRI data, of the main experiment will be used for the actual analysis of the feature of interest. For this, the MR data can be processed, e.g. by Fourier transform, as the analysis of processed data is much more convenient if the analysis of the feature is made by the human process operator. In a very preferred embodiment, the analysis itself is conducted using a second machine learning module, wherein the use of such machine learning module beneficially allows for the direct analysis of raw MR data and even undersampled raw MR data as e.g. disclosed in EP 4202427 A1 and EP 4202468 A1. The relevant scenarios are a method according to the invention, wherein the MR data comprises raw MR data and/or processed MR data, in particular, a Fourier transform in two or three dimensions.

Especially preferred is a method according to the invention, wherein the analysing of the predetermined feature in the industrial sample using the MR data of the industrial sample is made with an analysis module, using a further machine learning module,
wherein the analysis module comprises a memory storing the further machine learning module and a processor for controlling the analysis module, wherein the analysis module is configured to provide the MR data as an input to the further machine learning module and to analyse the MR data using the further machine learning module,
wherein the further machine learning module is trained for analysing the predetermined feature in industrial samples of the predefined sample type using a training set comprising MR data of different training samples of the predefined sample type comprising the predefined feature as well as information of interest regarding the predefined feature that were analysed in the training samples.

For the further machine learning module and the respective training set for training it, the above explanations and preferred embodiments apply accordingly. Preferred is a method according to the invention, wherein the inference module and the analysis module are provided using the same decentral data processing device, preferably an external server, preferably a cloud.

It is highly preferred to classify the industrial samples depending on the analysis of the feature. This means that two or more classes are provided that are based on a grouping criterion, wherein the industrial samples are assigned to one or more of these classes based on the analyis of the predetermined feature. For example, if the predetermined feature is the size of a yolk in an egg, the classes could e.g. be i) larger than X, ii) between X and Y and iii) less than Y, wherein e.g. only samples of class ii) would be further processed. In a very efficient embodiment this classification can be done automatically by the analysis module. Thus, preferred is a method according to the invention, further comprising the step of:
f) classifying the industrial sample based on the result of the analysis, wherein the classification is preferably conducted by the analysis module, wherein the analysis module is preferably configured to classify industrial samples of the predefined type based on the result of the analysis of the predetermined feature, wherein the multitude of industrial samples is most preferably conveyed out of the MR scanner and sorted based on the classification.

Taking into account the above disclosure, it is understood that a benefit of the present invention consists of the high usability and reliability of the fast analysis of predetermined features and optionally the fast classification of the industrial samples, that makes the method of the present invention particularly suited to control subsequent processing steps, like e.g. the transfer of eggs to a hatchery or the packaging of products that are free of impurities, based on the output of the method. Therefore, preferred is a method according to the invention, wherein subsequent processing steps of the industrial sample are controlled in dependence of the analysis of the predetermined feature. Furthermore, preferred is a method according to the invention, wherein the industrial sample is only provided for further processing if the result of the analysing, meets a predetermined quality criterion, wherein the industrial sample is preferably disposed and/or repurposed if the predetermined quality criterion is not met.

The invention also relates to an inference module for deriving one or more MR experimental parameters for use in a subsequent MR experiment for the analysis of a predetermined feature in an industrial sample by analysing navigator information comprising first MRI data recorded in a preparation experiment of the industrial sample, using a machine learning module, preferably in a method according to the invention,
wherein the inference module comprises a memory storing the machine learning module and a processor for controlling the inference module, wherein the inference module is configured to provide the navigator information as an input to the machine learning module and to analyse the navigator information using the machine learning module,
wherein the machine learning module is trained for deriving one or more MR experimental parameters for use in a subsequent MR experiment for the analysis of the predetermined feature in the industrial sample by analysing navigator information using a training set comprising navigator information of different training samples of the predefined sample type with the predetermined feature and corresponding MR experimental parameters used in a subsequent MR experiment for the analysis of the predetermined feature in the training sample,
wherein for a fraction of the training samples the subsequent MR experiment for the analysis of the predetermined feature meet a predefined quality criterion and wherein for a fraction of the training samples the subsequent MR experiment for the analysis of the predetermined feature did not meet a predefined quality criterion.

The invention also relates to a scanner system for conducting the method according to the invention, comprising:
a) an MR scanner for recording first MRI data of industrial samples of a predefined sample type in a preparation experiment to obtain navigator information comprising the first MRI data and for recording MR data of the industrial sample in a subsequent MR experiment,
b) a conveyor for conveying a multitude of industrial samples into the MR scanner, and
c) an inference module according to the invention, that is in communication with the MR scanner.

The invention also relates to computer program product comprising instructions which, when the program is executed by a computer, preferably by an inference module according to the invention, cause the computer to carry out step c) of the method according to the invention.

Also disclosed herein are a computer-readable data carrier having stored thereon the computer program product according to the invention as well as a data carrier signal carrying the computer program product according to the invention.

Hereinafter, the invention is described in more detail, wherein preferred embodiments of the invention are disclosed with respect to the figures. The figures show:
- Fig. 1: a schematic visualization of the steps of a preferred method according to the invention;
- Fig. 2: a schematic visualization of the principle of the method according to the invention; and
- Fig. 3: a schematic visualization of the structure of a preferred inference module according to the invention;
- Fig. 4: an exemplary visualization of one-dimensional projections acquired at different angles collected as first MRI data; and
- Fig. 5: an exemplary visualization of reducing the field of view in a subsequent MRI experiment depending on one-dimensional or two-dimensional first MRI data collected in a one-dimensional preparation MRI experiment.

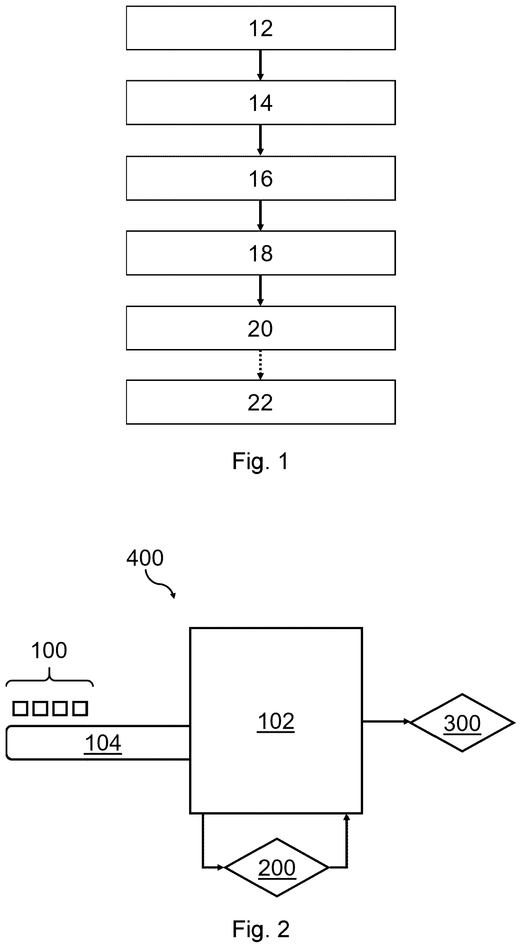

Fig. 1 and 2 provide a schematic visualization of a preferred method according to the invention for automated non-invasive analysis of a predetermined feature in a multitude of industrial samples 100 of a predefined sample type to facilitate the understanding of the present invention and provide an indication of the scanner system 400 of the present invention.

In an initial step 12 of the method, at least one industrial sample 100, for example an egg, is conveyed into an MR scanner 102, that is a MRI scanner. The MR scanner 102 comprises a magnet that generates a static magnetic field, wherein the magnetic field e.g. has a magnetic field strength in the range of 0.3 to 7 Tesla. The MR scanner 102 comprises magnetic gradient coils in three dimensions, configured to induce a magnetic gradient in the static magnetic field, and radio-frequency coils, configured to apply radio-frequency pulses. The MR scanner 102 comprises a measurement zone that is located in the center of the static magnetic field, so that the industrial sample 100 is in said measurement zone during the measurement.

As is shown schematically in fig. 2, several industrial samples 100 are conveyed into the MR scanner 102 by the conveyor 104. The conveyor 104 is e.g. controlled by a transport controller, which is e.g. governed by a central controller, that also supervises the other controllers within the MR scanner 102, e.g. through data channels or wireless communication.

In the example of fig. 2, the industrial samples 100 are arranged for conveying in a column, so that the method according to the invention can be applied for multiple industrial samples 100, sequentially.

In a subsequent step 14 a preparation MRI measurement is conducted on the industrial sample 100 to record first MRI data that can be used is the following step 16 to derive one or more MR experimental parameters for use in a subsequent MR experiment, wherein the subsequent MR experiment is the main experiment that predominately is used for actually analysis the predetermined feature in the industrial sample 100. The preparation MRI experiment can be conducted as a two-dimensional or higher dimensional MRI experiment, using efficiency enhancing but resolution reducing MRI acquisition methods, like gradient encoding methods and will for example have an overall measurement time of less than 100 ms, making it significant shorter than the main MR experiment.

Preferably, 1H-MR experiments are used for both the preparation MRI experiment and the subsequent MR experiment.

The MR experimental parameters can relate to both the hardware configuration as well as non-hardware related parameters, in particular regarding the field of view in a MRI experiment, and is therefore used to modify the MRI hardware control and/or the MRI sequence control.

The respective MR experimental parameters are derived using an inference module 200 that comprises a machine learning module 202 that is trained for deriving one or more MR experimental parameters for use in a subsequent MR experiment for the analysis of the predetermined feature in the industrial sample 100 by analysing navigator information. In the preferred embodiment of Fig. 1 and 2, the machine learning module 202 is trained to derive the MR experimental parameters directly from raw first MRI data, i.e. from unprocessed MRI that was e.g. not Fourier transformed.

For this purpose, the machine learning module 202 of the inference module 200 is trained using a training set comprising navigator information of different training samples of the predefined sample type with the predetermined feature and corresponding MR experimental parameters used in a subsequent MR experiment for the analysis of the predetermined feature in the training sample, wherein for a fraction of the training samples the subsequent MR experiment for the analysis of the predetermined feature meet a predefined quality criterion and wherein for a fraction of the training samples the subsequent MR experiment for the analysis of the predetermined feature did not meet a predefined quality criterion. In other words, the training set for the model comprises pairs of navigator experiments and the main MR experiments, typically between 10000 and 50000 trainings samples collected across several MR scanners 102 of the same scanner type to capture variability. The machine learning module 202 uses the ground truth location of the main feature from the main MRI experiment and the navigator experiments as input. Herein, optimal results can be achieved if this is at least complemented with trainings data from the identical MR scanner 102.

The MR experimental parameters thus derived are provided to the MR scanner 102 with a low-latency communication architecture that enables a data transfer between the MR scanner 102 and the inference module 200 in less than 10 ms.

The updated MR experimental parameters are used for conducting the main experiment, i.e. the recording of the MR data in the subsequent MR experiment in the subsequent step 18.

The respective MR data is used to analyse the predetermined feature in the industrial sample 100 in the following step 20. In the preferred embodiment of Fig. 2 the actual analysis is conducted using a deep learning approach as well. Specifically, the analysing of the predetermined feature in the industrial sample 100 using the MR data of the industrial sample 100 is made with an analysis module 300, using a further machine learning module 302, wherein the further machine learning module 302 is trained for analysing the predetermined feature in industrial samples 100 of the predefined sample type using a training set comprising MR data of different training samples of the predefined sample type comprising the predefined feature as well as information of interest regarding the predefined feature that were analysed in the training samples.

Fig. 1 depicts a preferred embodiment of the method according to the invention that comprises an additional step 22. In this step 22, the industrial sample 100 is also classified, preferably by the analysis module 300. The classification is based on the result of the analysis performed in the step 20. The classification performed in step 22 can be used for sorting the industrial samples 100 based on the result, preferably directly upon conveying the industrial samples 100 out of the MR scanner 102.

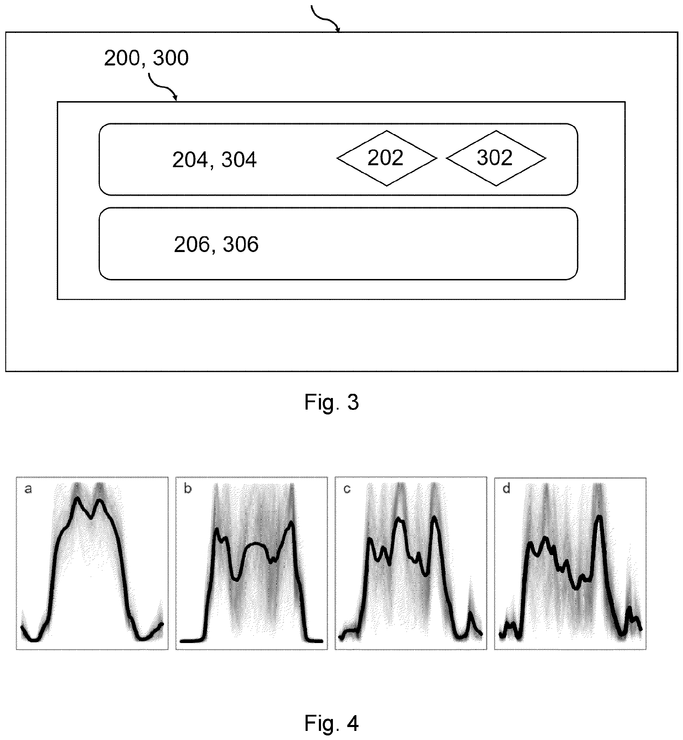

Fig. 3 shows a schematic visualization of a preferred centralized cloud server 500 that provides the processor 206, 306 as well as the memory 204, 304 and comprises both the machine learning module 202 and the further machine learning module 302. Thus, the cloud server 500 can function as both the inference module 200 and the analysis module 300 in the method according to the invention. In this example both the machine learning module 202 and the further machine learning module are based on an artificial neural network algorithm or deep learning algorithm.

In the preferred embodiment depicted in fig. 3, neither the inference module 200 nor the analysis module 300 comprise means for providing visualized output of processed MRI data like MRI images, for example in the form of a display but are rather configured to directly control the MR scanner and to provide the required analysis result, respectively.

Fig. 4 shows an exemplary visualization of one-dimensional projections acquired at different angles collected as first MRI data. More specifically, Fig. 4 shows representative one-dimensional projections across 4 angles of a transversal plane of a kiwi, acquired with gradient echo radial encoding at angles of 0°, 45°, 90° and 135°. The plots show all projections of a training set in gray and the mean value of the projections as the solid line.

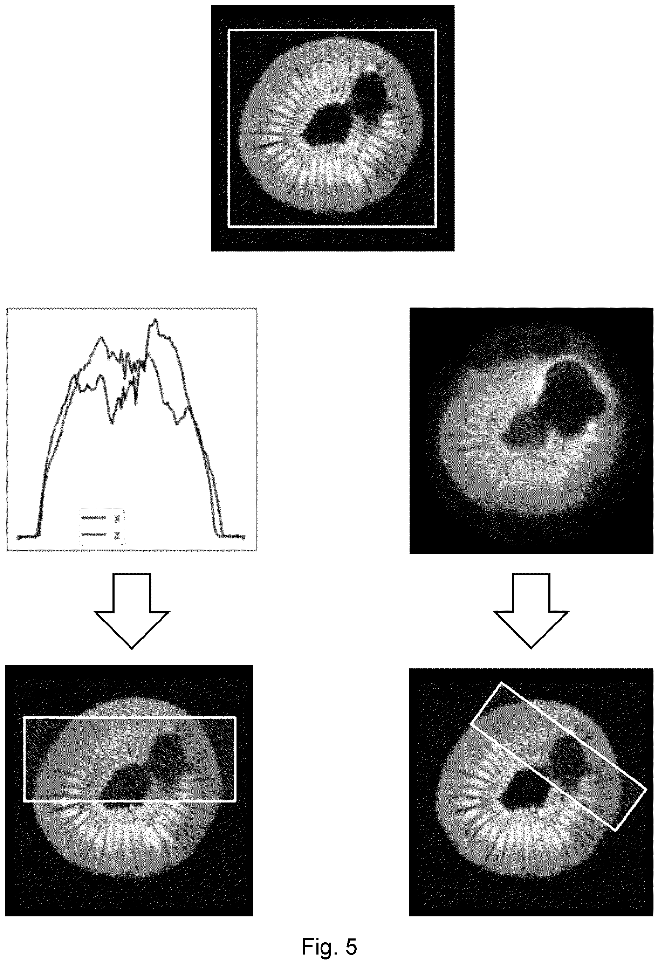

Fig. 5 visualize the fully sampled MRI image, that would be obtained in a regular MRI experiment (top) together with a representation of the first MRI data collected in a one- or two-dimensional preparation experiment (middle), as well as an indication of a reduced field of view that can be chosen for a subsequent MRI experiment based on the first MRI data (bottom).

More specifically, the top picture of Fig. 5 is a high-quality MRI image of a kiwi acquired with a gradient echo sequence. The image shows a transversal slice of a kiwi with a damaged region. The white square represents the field of view needed to cover the full sample in an MRI experiment to fully analyze the feature (in this case the damaged region).

In the middle of Fig. 5, the result of a one-dimensional (left) or two-dimensional (right) preparation experiment is shown. The left picture shows one-dimensional projection across two orthogonal planes of the kiwi, acquired with gradient echo radial encoding. The right picture shows a two-dimensional navigator information acquired with gradient echo spiral encoding across a transversal slice of the kiwi at low resolution. The pictures on the bottom of Fig. 5 each show a high-quality image of a kiwi. The square indicates the reduced field-of-view needed in the second MRI experiment to fully analyze the feature (in this case the damaged region), that is obtained by inference from the navigator information obtained from the respective one- or two-dimensional preparation experiment.

### Reference Signs

- 12: process step a)
- 14: process step b)
- 16: process step c)
- 18: process step d)
- 16: process step e)
- 18: process step f)

- 100: industrial samples
- 102: MR scanner
- 104: conveyor

- 200: inference module
- 202: machine learning module
- 204: memory
- 206: processor

- 300: analysis module
- 302: further machine learning module
- 304: memory
- 306: processor

- 400: Scanner system

- 500: Cloud server

## Claims

1. Method for automated non-invasive analysis of a predetermined feature in a multitude of industrial samples (100) of a predefined sample type, the method comprising the steps of:
a) conveying an industrial sample (100) of the predefined sample type into an MR scanner (102),
b) recording in a preparation MRI experiment first MRI data of the industrial sample (100) with the MR scanner (102) to obtain a navigator information comprising the recorded first MRI data,
c) analysing the navigator information with an inference module (200) for deriving one or more MR experimental parameters for use in a subsequent MR experiment for the analysis of the predetermined feature in the industrial sample (100) using a machine learning module (202),
d) recording in a subsequent MR experiment MR data of the industrial sample (100) with the MR scanner (102) using the derived one or more MR experimental parameters, and
e) analysing the predetermined feature in the industrial sample (100) using the MR data of the industrial sample (100),
wherein the inference module (200) comprises a memory (204) storing the machine learning module (202) and a processor (206) for controlling the inference module (200), wherein the inference module (200) is configured to provide the navigator information as an input to the machine learning module (202) and to analyse the navigator information using the machine learning module (202),
wherein the machine learning module (202) is trained for deriving one or more MR experimental parameters for use in a subsequent MR experiment for the analysis of the predetermined feature in the industrial sample (100) by analysing navigator information using a training set comprising navigator information of different training samples of the predefined sample type with the predetermined feature and corresponding MR experimental parameters used in a subsequent MR experiment for the analysis of the predetermined feature in the training sample,
wherein for a fraction of the training samples the subsequent MR experiment for the analysis of the predetermined feature meet a predefined quality criterion and wherein for a fraction of the training samples the subsequent MR experiment for the analysis of the predetermined feature did not meet a predefined quality criterion.

2. Method according to claim 1, wherein the preparation MRI experiment is conducted as a two-dimensional or higher dimensional MRI experiment, using efficiency enhancing but resolution reducing MRI acquisition methods.

3. Method according to any one of claims 1 or 2, wherein the preparation MRI experiment is conducted with an overall measurement time of 200 ms or less.

4. Method according to any one of claims 1 to 3, wherein the method is applied for two or more industrial samples (100) simultaneously, wherein the first MRI data is collected for each industrial sample (100) individually to obtain a navigator information for each industrial sample (100), or wherein the method is applied for two or more industrial samples (100) simultaneously, wherein the first MRI data is collected for a set of two or more industrial samples (100) combined to obtain a navigator information for the set of two or more industrial samples (100).

5. Method according to any one of claims 1 to 4, wherein the first MRI data comprises spatial information relating to the predetermined feature.

6. Method according to any one of claims 1 to 5, wherein the preparation MRI experiment comprises two or more subexperiments for the industrial sample (100), wherein the subexperiments are conducted at different positions in the industrial sample (100) and/or along different lines through the industrial sample (100) and/or along different planes through the industrial sample (100).

7. Method according to any one of claims 1 to 6, wherein the MR experimental parameters comprise experimental parameters regarding the hardware configuration of the MR scanner (102), preferably regarding the conveyor (104) speed and/or the sample positioning in the MR scanner (102) and/or configuration parameters regarding the magnetic field and/or configuration parameters regarding the gradients and acquisition frequency.

8. Method according to any one of claims 1 to 7, wherein the MR experimental parameters comprise experimental parameters regarding the number of scans and/or the pulse sequence and/or the field of view of the MRI experiment.

9. Method according to any one of claims 1 to 8, wherein the subsequent MR experiment is an MRI experiment.

10. Method according to any one of claims 1 to 9, wherein the method is operated with a low-latency communication architecture for providing the navigator information to the inference module, analysing the navigator information with the inference module and providing the derived MR experimental parameters to the MR scanner, wherein the low-latency communication architecture enables the transfer of navigator information between the MR scanner and the inference module, the analysing of the navigator information with the inference module and the provision of the MR experimental parameters to the MR scanner in less than 300 ms.

11. Method according to any one of claims 1 to 10, wherein the machine learning module (202) is based on a deep learning network or an artificial neural network.

12. Method according to any one of claims 1 to 11, wherein the analysing of the predetermined feature in the industrial sample (100) using the MR data of the industrial sample (100) is made with an analysis module (300), using a further machine learning module (302),
wherein the analysis module (300) comprises a memory (304) storing the further machine learning module (302) and a processor (306) for controlling the analysis module (300), wherein the analysis module (300) is configured to provide the MR data as an input to the further machine learning module (302) and to analyse the MR data using the further machine learning module (302),
wherein the further machine learning module (302) is trained for analysing the predetermined feature in industrial samples (100) of the predefined sample type using a training set comprising MR data of different training samples of the predefined sample type comprising the predefined feature as well as information of interest regarding the predefined feature that were analysed in the training samples.

13. Inference module (200) for deriving one or more MR experimental parameters for use in a subsequent MR experiment for the analysis of a predetermined feature in an industrial sample (100) by analysing navigator information comprising first MRI data recorded in a preparation experiment of the industrial sample (100), using a machine learning module (302), preferably in a method according to any one of the claims 1 to 12,
wherein the inference module (200) comprises a memory (204) storing the machine learning module (202) and a processor (206) for controlling the inference module (200), wherein the inference module (200) is configured to provide the navigator information as an input to the machine learning module (202) and to analyse the navigator information using the machine learning module (202),
wherein the machine learning module (202) is trained for deriving one or more MR experimental parameters for use in a subsequent MR experiment for the analysis of the predetermined feature in the industrial sample (100) by analysing navigator information using a training set comprising navigator information of different training samples of the predefined sample type with the predetermined feature and corresponding MR experimental parameters used in a subsequent MR experiment for the analysis of the predetermined feature in the training sample,
wherein for a fraction of the training samples the subsequent MR experiment for the analysis of the predetermined feature meet a predefined quality criterion and wherein for a fraction of the training samples the subsequent MR experiment for the analysis of the predetermined feature did not meet a predefined quality criterion.

14. Scanner system (400) for conducting the method according to any one of claims 1 to 12, comprising:
a) an MR scanner (102) for recording first MRI data of industrial samples (100) of a predefined sample type in a preparation experiment to obtain navigator information comprising the first MRI data and for recording MR data of the industrial sample (100) in a subsequent MR experiment,
b) a conveyor (104) for conveying a multitude of industrial samples (100) into the MR scanner (102), and
c) an inference module (200) according to claim 13, that communicates with the MR scanner (102).

15. Computer program product comprising instructions which, when the program is executed by a computer, preferably by an inference module (200) according to claim 13, cause the computer to carry out step c) of the method according to any one of the claims 1 to 12.
